# EUROPEAN PATENT SPECIFICATION

(11) **EP 1 858 074 B1**
(45) Date of publication and mention of the grant of the patent: **13.07.2016**
(21) Application number: 07102983.9
(22) Date of filing: 23.02.2007
(51) Int. Cl.: H01L 27/115, H01L 27/112, H01L 27/24, H01L 45/00, G11C 13/00

(54) **Nonvolatile memory device using oxygen-deficient metal oxide layer and method of manufacturing the same**
Nichtflüchtige Speichervorrichtung unter Verwendung einer sauerstoffarmen Metalloxidschicht und Herstellungsverfahren dafür
Dispositif de mémoire non volatile utilisant une couche d'oxyde de métal déficiente en oxygène et procédé de fabrication correspondant

(30) Priority: 19.05.2006 KR 20060045154
(43) Date of publication of application: 21.11.2007
(73) Proprietor: Samsung Electronics Co., Ltd., Suwon-si, Gyeonggi-do, 443-742 (KR)
(72) Inventor: Cho, Sung-il c/o Samsung Advanced Institute of Technology, Gyeonggi-do (KR); Cho, Choong-rae c/o Samsung Advanced Institute of Technology, Gyeonggi-do (KR); Lee, Eun-hong c/o Samsung Advanced Institute of Technology, Gyeonggi-do (KR); Yoo, In-kyeong c/o Samsung Advanced Institute of Technology, Gyeonggi-do (KR)
(74) Representative: Greene, Simon Kenneth

(56) References cited:
- EP-A- 1 484 799
- US-A1- 2005 247 921
- US-A1- 2006 054 950
- XIN CHEN ET AL: "Perovskite RRAM devices with metal/insulator/PCMO/metal heterostructures" NON-VOLATILE MEMORY TECHNOLOGY SYMPOSIUM, 2005 DALLAS, TX, USA 7-10 NOV. 2005, PISCATAWAY, NJ, USA,IEEE, 7 November 2005 (2005-11-07), pages 125-128, XP010854264 ISBN: 978-0-7803-9408-7
- HYUNJUN SIM ET AL: "Excellent Resistance Switching Characteristics of Pt/Single-crystal Nb-Doped SrTiO3 Schottky Junction" NON-VOLATILE SEMICONDUCTOR MEMORY WORKSHOP, 2006. IEEE NVSMW 2006. 21S T FEB 12-16 2006, PISCATAWAY, NJ, USA,IEEE, 12 February 2006 (2006-02-12), pages 88-89, XP010916678 ISBN: 978-1-4244-0027-0

## Description

### BACKGROUND OF THE INVENTION

The present invention relates to a nonvolatile memory device that uses an oxygen-deficient metal oxide and a method of manufacturing the same, and more particularly, to a nonvolatile memory device having a storage node in which an oxygen-deficient metal oxide layer is formed between a lower electrode and a data layer and a method of manufacturing the same.

A conventional dynamic random access memory (DRAM) consists of a unit cell of 1T/1C (one transistor and one capacitor) structure. As the size of a device decreases, the process difficultness for manufacturing the capacitor increases, and thus, the high yield manufacturing of DRAM cells is difficult. Therefore, the necessity of a memory that can replace the conventional DRAM and has non-volatility is greatly required. Attempts have been made to realize and develop high integration density and low power consumption of DRAMs, non-volatility of flash memories, and high operation speeds of static random access memories (SRAMs) as next generation memories. Such devices that draw attentions as next generation memories include phase change RAMs (PRAMs), nano floating gate memories (NFGMs), resistance RAMs (ReRAMs), polymer RAMs (PoRAMs), magnetic RAMs (MRAMs), and molecular electronic devices.

The ReRAM device has a Metal Insulating Metal (MIM) structure using a metal oxide, and shows memory characteristics that when an appropriate electrical signal is applied, the state of the MIM structure changes from a high resistance non-conductive state, i.e., an off-state to a low resistance conductive state, i.e., an on-state. For the acronym MIM, M means upper and lower metal electrodes, and I means a data storage layer formed of an insulating material.

When switching is repeated in a node storage of a conventional MIM memory cell structure, the deviation of the distribution of the set and reset voltage values Vₛₑₜ and Vᵣₑₛₑₜ that is applied to the storage node is large, and the distribution of the resistance values Rₒₙ and R_{off} of the storage node according to on and off states is not uniform.

US2005/0247921 discloses a memory device with a graded resistance layers having different oxygen concentrations. A graph of resistance against oxygen concentration for NiO is presented.

US 2006/0054950 describes an NiO layer used in a memory cell - the NiO is not stochiometric, and when represented as NiₓO_{y} with x = 1 has values of y from 0.66 to 0.95.

### SUMMARY OF THE INVENTION

The present invention provides a nonvolatile memory device having an improved structure in order to have stable memory switching characteristics in a storage node.

The present invention also provides a method of manufacturing a nonvolatile memory device having a storage node.

According to an aspect of the present invention, there is provided a non-volatile memory device according to claim 1. The switching device may include a transistor or a diode.

The oxygen-deficient metal oxide layer may be a metal oxide layer having an oxygen vacancy and has a resistivity greater than a conductive metal oxide and less than the data storage layer.

The oxygen-deficient metal oxide layer may be a ZnO layer.

The oxygen-deficient metal oxide layer may have a thickness in a range of 1 to 50 nm.

The upper and lower electrodes are formed of a material selected from the group consisting of Pt, Ru, Ir, Pd, Au, Cr, Ni, Cu, and TiN.

The lower electrode may be formed of Ru.

According to another aspect of the present invention, there is provided a method of manufacturing a nonvolatile memory deviceaccording to claim 8.

The switching device may include a transistor or a diode.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view illustrating a nonvolatile memory device according to an embodiment of the present invention;
FIG. 2 is a cross-sectional view illustrating a structure of a storage node of the nonvolatile memory device according to an embodiment of the present invention;
FIGS. 3A through 3D are cross-sectional views illustrating a method of manufacturing a storage node according to an embodiment of the present invention;
FIG. 4 is an I-V curve showing the switching characteristics of a nonvolatile memory device according to an embodiment of the present invention;
FIG. 5 is a n I-V curve showing the switching characteristics of a conventional nonvolatile memory device;
FIG. 6 is a graph showing the distribution of set and reset voltage values applied to a nonvolatile memory device according to an embodiment of the present invention;
FIG. 7 is a graph showing the distribution of set and reset voltage values applied to a conventional nonvolatile memory device;
FIG. 8 is a graph showing the distribution of resistance values of a storage node according to on/off states during the switching of a nonvolatile memory device according to an embodiment of the present invention; and
FIG. 9 is a graph showing the distribution of resistance values of a storage node according to on/off states during the switching of a conventional nonvolatile memory device.

### DETAILED DESCRIPTION OF THE INVENTION

The present invention will now be described more fully with reference to the accompanying drawings in which exemplary embodiments of the invention are shown.

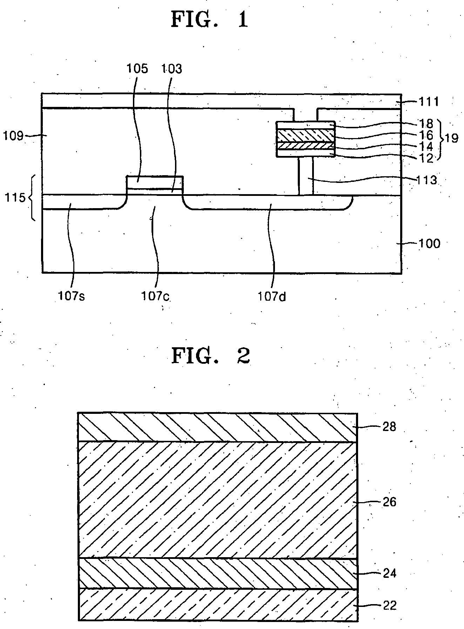

FIG. 1 is a cross-sectional view illustrating a nonvolatile memory device according to an embodiment of the present invention.

Referring to FIG. 1, the nonvolatile memory device includes a transistor 115 and a storage node 19 connected to the transistor 115. The transistor 115 includes a source 107S, a drain 107D, a channel 107C, and a gate electrode 105. The storage node 19 includes an upper electrode 18, a lower electrode 12, an oxygen-deficient metal oxide layer 14 and a data storage layer 16 interposed between the upper electrode 18 and the lower electrode 12 and an insulating layer 109 is disposed between the storage node 19 and the transistor 115. The storage node 19 is connected to the transistor 115 by a conductive contact plug 113, and a plate electrode 111 is disposed on the upper electrode 18 of the storage node 19.

FIG. 2 is a cross-sectional view illustrating a structure of the storage node of the nonvolatile memory device according to an embodiment of the present invention. Referring to FIG. 2, the storage node included in the nonvolatile memory device according to an embodiment of the present invention includes the lower electrode 22, the oxygen-deficient metal oxide layer 24 formed on the lower electrode 22, the data storage layer 26 formed on the oxygen-deficient metal oxide layer 24, and the upper electrode 28 formed on the data storage layer 26.

The upper and lower electrodes 28 and 22 can be formed of more than one material selected from the group consisting of Pt, Ru, Ir, Pd, Au, Cr, Ni, Cu, and TiN, and preferably, the upper electrode 28 is formed of Pt and the lower electrode 22 is formed of Ru. The upper and lower electrodes 28 and 22 may be formed to a thickness in a range from 10nm to 200nm using a sputtering method, an electron beam deposition method, or a chemical vapour deposition (CVD) method.

The oxygen-deficient metal oxide layer 24 formed on the lower electrode 22 denotes a metal oxide layer that includes an oxygen vacancy. The oxygen vacancy included in the metal oxide layer absorbs oxygen when a voltage is applied, and the oxygen concentrated at an interface between the data storage layer 26 and the oxygen-deficient metal oxide layer 24 increases the switching characteristics of a memory by influencing the disconnection to a metal filament. The oxygen-deficient metal oxide layer is a metal oxide layer having oxygen vacancy and has resistivity greater than a conductive metal oxide (IrO₂, RuO₂, SrRuO₃, MoO₂, OsO₂, Re02, RhO₂, WO₂) and less than the data storage layer (NiO).

The oxygen-deficient metal oxide layer 24 can be formed to a thickness in a range from 1nm to 50nm using a metal oxide, specifically, ZnO, ITO, IZO, ZrO, or RuO₂. When the thickness of the oxygen-deficient metal oxide layer 24 exceeds 50nm, the switching characteristics of the memory are not exhibited.

The oxygen-deficient metal oxide layer 24 can be formed using a sputtering method, a pulse laser deposition method, a CVD method, an organic metal vapor deposition method, a sol-gel method, or a spray thermal decomposition method.

The oxygen-deficient metal oxide layer 24 may be formed of ZnO.

ZnO can be formed to an insulator, a semiconductor, or a conductor according to process conditions and method of forming, and when a ZnO thin film is formed, the degree of conductivity and oxygen vacancy varies according to the oxygen partial pressure. More specifically, it is known that a lot of oxygen vacancies are formed when the ZnO thin film is formed at a low oxygen partial pressure. As described above, ZnO may be a desirable material since the formation of oxygen vacancies can be controlled together with the conductivity characteristics of the ZnO.

To form an oxygen-deficient metal oxide layer 24 using ZnO, the oxygen-deficient metal oxide layer 24 may be formed using a ZnO target as a raw material at an oxygen partial pressure of 50% or less by additionally injecting oxygen at a temperature of 50°C or less using a reactive sputtering method.

The data storage layer 26 may be formed of a transitional metal oxide having variable resistance characteristics. More specifically, the data storage layer 26 can be formed of a material selected from the group consisting of NiO, Nb₂O₅, TiO₂, Al₂O₃, V₂O₅, WO₃, ZnO, and CoO.

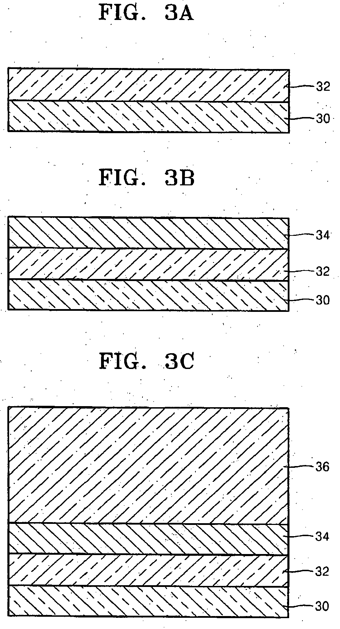

FIGS. 3A through 3D are cross-sectional views illustrating a method of manufacturing a storage node included in a non-volatile memory device according to an embodiment of the present invention. In a non-volatile memory device, the method of manufacturing a semiconductor switching device that includes a source, drain, channel, and a gate electrode is well known in the art, thus, the detailed descriptions thereof will be omitted.

Referring to FIG. 3A, a lower electrode 32 is formed on a silicon substrate 30. The lower electrode 32 can be formed of at least one material selected from the group consisting of Pt, Ru, Ir, Pd, Au, Cr, Ni, Cu, and TiN, and preferably, Ru. The lower electrode 32 may be formed to a thickness in a range from 10 to 200 nm using a sputtering method, an electron beam deposition method, or a CVD method.

Referring to FIG. 3B, an oxygen-deficient metal oxide layer 34 is formed on the lower electrode 32. The oxygen-deficient metal oxide layer 34 can be formed to a thickness in a range from 1 to 50 nm using a metal oxide such as ZnO, ITO, IZO, ZrO, RuO₂, etc.

The oxygen-deficient metal oxide layer 34 can be formed using a sputtering method, a pulse laser deposition method, a CVD method, an organometal vapour deposition method, a sol-gel method, or a spray thermal decomposition method.

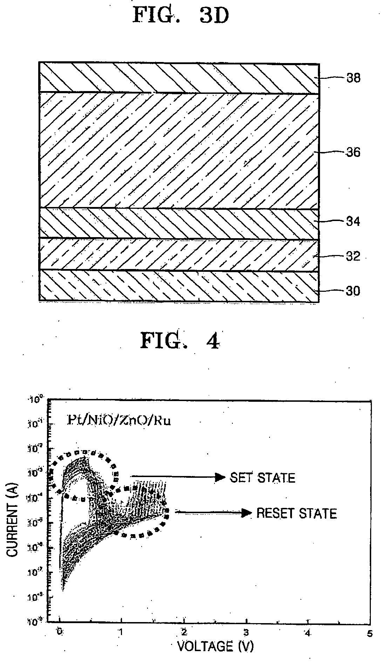

Referring to FIGS. 3C and D, a data storage layer 36 is formed on the oxygen-deficient metal oxide layer 34, and an upper electrode 38 is formed on the data storage layer 36.

The data storage layer 36 can be formed of a material selected from the group consisting of NiO, Nb₂O₅, TiO₂, Al₂O₃, V₂O₅, WO₃, ZnO, and CoO.

The upper electrode 38 can be formed of the same material as the lower electrode 32, and preferably Pt.

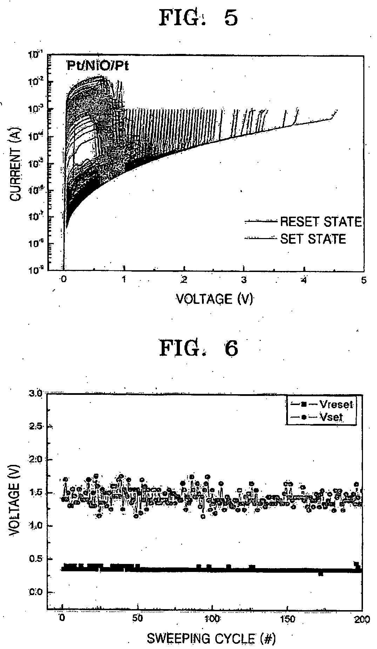

FIG. 4 is an I-V curve showing the switching characteristics of a nonvolatile memory device that includes a storage node having a Pt/NiO/ZnO/Ru structure according to an embodiment of the present invention. FIG. 5 is an I-V curve showing the switching characteristics of a conventional nonvolatile memory device that includes a storage node having a Pt/NiO/Pt structure in which the oxygen-deficient metal oxide layer 34 is not included.

Referring to FIGS. 4 and 5, the storage node having the Pt/NiO/ZnO/Ru structure realizes a uniform and stable distribution deviation of set and reset voltage values Vₛₑₜ and Vᵣₑₛₑₜ that are applied to the storage node when compared to that of the conventional Pt/NiO/Pt structure. Here, Vₛₑₜ is a voltage that sets transition, and Vᵣₑₛₑₜ is a voltage at maximum current peak when transition is reset.

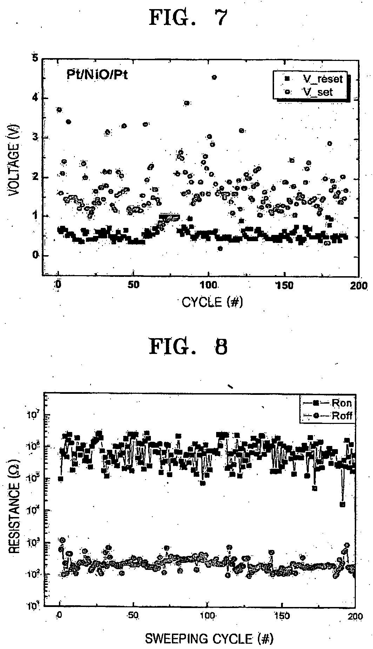

FIG. 6 is a graph showing the distribution of set and reset voltage values applied to a storage node having a Pt/NiO/ZnO/Ru structure according to an embodiment of the present invention. FIG. 7 is a graph showing the distribution of set and reset voltage values applied to a storage node having a conventional Pt/NiO/Pt structure.

Referring to FIGS. 6 and 7, it is seen that the standard deviation of the Vₛₑₜ and Vᵣₑₛₑₜ with respect to the switching cycle in the storage node having a Pt/NiO/ZnO/Ru structure according to an embodiment of the present invention decreases when compared to the conventional storage node having the Pt/NiO/Pt structure.

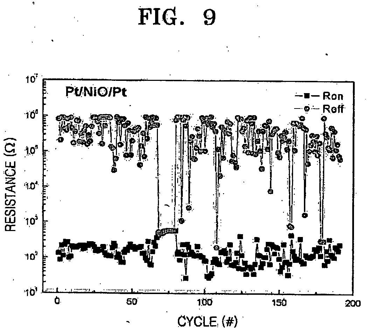

FIG. 8 is a graph showing the distribution of resistance values of a storage node having a Pt/NiO/ZnO/Ru structure according to an embodiment of the present invention according to on/off states when the storage node is switched. FIG. 9 is a graph showing the distribution of resistance values of a conventional storage node having a Pt/NiO/Pt structure according to on/off states when the conventional storage node is switched.

Referring to FIGS. 8 and 9, in the storage node having the Pt/NiO/ZnO/Ru structure according to an embodiment of the present invention, the standard deviation of Ron and Roff with respect to the switching cycle decreases when compared to the conventional storage node having the Pt/NiO/Pt structure.

Accordingly, the memory characteristics improve in a storage node structure according to the present invention through the reduction of the standard deviation of Ron and Roff.

As described above, according to the present invention, stable memory switching characteristics can be obtained by employing an oxygen-deficient metal oxide in a storage node. More specifically, when switching is repeated, the standard deviation of set and reset voltages applied to the storage node and the standard deviation of resistance according to on and off states can be reduced.

## Claims

1. A non-volatile memory device having a switching device and a storage node connected to the switching device, wherein the storage node comprises:
a lower electrode (12,22);
an oxygen-deficient metal oxide layer (14,24) formed on the lower electrode;
a data storage layer (16,26) formed on the oxygen-deficient metal oxide layer; and
an upper electrode (18,28) formed on the data storage layer.
wherein the storage node is configured to absorb oxygen at one or more oxygen vacancies of the oxygen-deficient metal oxide layer upon application of a voltage
wherein the oxygen-deficient metal oxide layer (14,24) is formed of a material having an oxygen vacancy selected from the group consisting of ZnO, ITO, IZO, ZrO, and RuO₂.
wherein the data storage layer (16,26) is formed of a material selected from the group consisting of NiO, Nb₂O₅, TiO₂, Al₂O₃, V₂O₅, WO₃, ZnO, and CoO.

2. The nonvolatile memory device of claim 1, wherein the oxygen-deficient metal oxide layer (14,24) is a metal oxide layer having an oxygen vacancy and has a resistivity greater than a conductive metal oxide and less than the data storage layer.

3. The nonvolatile memory device of claim 2, wherein the conductive metal oxide is formed of a material selected from the group consisting of IrO₂, RuO₂, SrRuO₃, MoO₂, OsO₂, ReO₂, RhO₂, and WO₂.

4. The nonvolatile memory device of claim 2 or 3, wherein the oxygen-deficient metal oxide layer (14,24) is a ZnO layer.

5. The nonvolatile memory device of claim 4, wherein the oxygen-deficient metal oxide layer (14,24) has a thickness in the range of 1 to 50 nm.

6. The nonvolatile memory device of any preceding claim, wherein the upper and lower electrodes (12,18,22,28) are formed of a material selected from the group consisting of Pt, Ru, Ir, Pd, Au, Cr, Ni, Cu, and TiN.

7. The nonvolatile memory device of any preceding claim, wherein the lower electrode (12,22) is formed of Ru.

8. A method of manufacturing a nonvolatile memory device, comprising:
preparing a switching device;
forming a lower electrode (12,22) connecting to the switching device;
forming an oxygen-deficient metal oxide layer (14,24) having an oxygen vacancy on the lower electrode;
forming a data storage layer (16,26) on the oxygen-deficient metal oxide layer; and
forming an upper electrode on the data storage layer; wherein the storage node is configured to absorb oxygen at one or more oxygen vacancies of the oxygen-deficient metal oxide layer upon application of a voltage
wherein the oxygen-deficient metal oxide layer (14,24) is formed of a material having an oxygen vacancy selected from the group consisting of ZnO, ITO, IZO, ZrO, and RuO₂.
wherein the data storage layer (16,26) is formed of a material selected from the group consisting of NiO, Nb₂O₅, TiO₂, Al₂O₃, V₂O₅, WO₃, ZnO, and CoO.

9. The method of claim 8, wherein the oxygen-deficient metal oxide layer (14,24) is formed of a material selected from the group consisting of ZnO, ITO, IZO, ZrO, and RuO₂.

10. The method of claim 9 wherein the oxygen-deficient metal oxide layer (14,24) has a thickness in the range of 1 to 50 nm.

11. The method of claim 9 or 10, wherein the oxygen-deficient metal oxide layer (14,24) is formed using a sputtering method, a pulse laser deposition method, a CVD (chemical vapor deposition) method, an organic metal vapor deposition method, a sol-gel method, or a spray thermal decomposition method.

12. The method of claim 8, 9 or 10, wherein the oxygen-deficient metal oxide layer (14,24) is a ZnO layer.

13. The method of any of claims 8 to 12, wherein the ZnO layer (14,24) is formed using a ZnO target as a raw material at an oxygen partial pressure of 50% or less by additionally injecting oxygen at a temperature of 50°C or less using a reactive sputtering method

14. The method of any of claims 8 to 13, wherein the upper and lower electrodes (12,18,22,28) are formed of a material selected from the group consisting of Pt, Ru, Ir, Pd, Au, Cr, Ni, Cu, and TiN using a sputtering method, an electron beam deposition method, or a CVD method.

15. The method of claim 14, wherein the lower electrode (12,22) is formed of Ru.

## Patentansprüche

1. Nichtflüchtige Speichervorrichtung, die eine Schaltvorrichtung und einen Storage Node hat, der mit der Schaltvorrichtung verbunden ist, wobei der Storage Node Folgendes umfasst:
eine untere Elektrode (12, 22);
eine sauerstoffarme Metalloxidschicht (14, 24), die auf der unteren Elektrode gebildet wird;
eine Datenträgerschicht (16, 26), die auf der sauerstoffarmen Metalloxidschicht gebildet wird; und
eine obere Elektrode (18, 28), die auf der Datenträgerschicht gebildet wird,
wobei der Storage Node konfiguriert ist, um Sauerstoff an einer oder mehreren Sauerstoffleerstellen der sauerstoffarmen Metalloxidschicht beim Anlegen der Spannung zu absorbieren,
wobei die sauerstoffarme Metalloxidschicht (14, 24) gebildet wird aus einem Material, das eine Sauerstoffleerstelle hat, ausgewählt aus der Gruppe, bestehend aus ZnO, ITO, IZO, ZrO und RuO₂,
wobei die Datenträgerschicht (16, 26) gebildet wird aus einem Material, ausgewählt aus der Gruppe, bestehend aus NiO, Nb₂O₅, TiO₂, Al₂O₃, V₂O₅, WO₃, ZnO, und CoO.

2. Nichtflüchtige Speichervorrichtung nach Anspruch 1, wobei die sauerstoffarme Metalloxidschicht (14, 24) eine Metalloxidschicht ist, die eine Sauerstoffleerstelle hat und eine größere Resistivität als ein leitfähiges Metalloxid und eine kleinere Resistivität als die Datenträgerschicht hat.

3. Nichtflüchtige Speichervorrichtung nach Anspruch 2, wobei das leitfähige Metalloxid gebildet wird aus einem Material, ausgewählt aus der Gruppe, bestehend aus IrO₂, RuO₂, SrRuO₃, MoO₂, OsO₂, ReO₂, RhO₂ und WO₂.

4. Nichtflüchtige Speichervorrichtung nach Anspruch 2 oder 3, wobei die sauerstoffarme Metalloxidschicht (14, 24) eine ZnO-Schicht ist.

5. Nichtflüchtige Speichervorrichtung nach Anspruch 4, wobei die sauerstoffarme Metalloxidschicht (14, 24) eine Dicke im Bereich zwischen 1 und 50 nm hat.

6. Nichtflüchtige Speichervorrichtung nach einem der vorangegangen Ansprüche, wobei die oberen und unteren Elektroden (12, 18, 22, 28) aus einem Material bestehen, ausgewählt aus der Gruppe, bestehend aus Pt, Ru, Ir, Pd, Au, Cr, Ni, Cu und TiN.

7. Nichtflüchtige Speichervorrichtung nach einem der vorangegangenen Ansprüche, wobei die untere Elektrode (12, 22) aus Ru besteht.

8. Verfahren zum Herstellen einer nichtflüchtigen Speichervorrichtung, umfassend:
Herstellen einer Schaltvorrichtung;
Herstellen einer unteren Elektrode (12, 22), die an die Schaltvorrichtung anschließt;
Herstellen einer sauerstoffarmen Metalloxidschicht (14, 24), die eine Sauerstoffleerstelle an der unteren Elektrode hat;
Herstellen einer Datenträgerschicht (16, 26) auf der sauerstoffarmen Metalloxidschicht; und
Herstellen einer oberen Elektrode auf der Datenträgerschicht;
wobei der Storage Node konfiguriert ist, Sauerstoff an einer oder mehreren Sauerstoffleerstelen der sauerstoffarmen Metalloxidschicht beim Anlegen einer Spannung zu absorbieren,
wobei die sauerstoffarme Metalloxidschicht (14, 24) gebildet wird aus einem Material, das eine Sauerstoffleerstelle hat, ausgewählt aus der Gruppe, bestehend aus ZnO, ITO, IZO, ZrO und RuO₂,
wobei die Datenträgerschicht (16, 26) gebildet wird aus einem Material, ausgewählt aus der Gruppe, bestehend aus NiO, Nb₂O₅, TiO₂, Al₂O₃, V₂O₅, WO₃, ZnO und CoO;

9. Verfahren nach Anspruch 8, wobei die sauerstoffarme Metalloxidschicht (14, 24) gebildet wird aus einem Material, ausgewählt aus der Gruppe, bestehend aus ZnO, ITO, IZO, ZrO und RuO₂.

10. Verfahren nach Anspruch 9, wobei die sauerstoffarme Metalloxidschicht (14, 24) eine Dicke im Bereich zwischen 1 und 50 nm hat.

11. Verfahren nach Anspruch 9 oder 10, wobei die sauerstoffarme Metalloxidschicht (14, 24) mittels eines Sputter-Verfahrens, eines Laserstrahlverdampfungsverfahrens, eines chemischen Gasphasenabscheidungverfahrens, eines metallorganischen Gasphasenabscheidungsverfahrens, eines Sol-Gel-Verfahrens oder eines thermischen Aufschlusssprühverfahrens gebildet wird.

12. Verfahren nach Anspruch 8, 9 oder 10, wobei die sauerstoffarme Metalloxidschicht (14, 24) eine ZnO-Schicht ist.

13. Verfahren nach einem der Ansprüche 8 bis 12, wobei die ZnO-Schicht (14, 24) gebildet wird mittels eines ZnO-Ziels als ein Rohstoff bei einem Sauerstoffpartialdruck von 50 % oder weniger durch zusätzliches Einspritzen von Sauerstoff bei einer Temperatur von 50 °C oder darunter mittels eines aktiven Sputter-Verfahrens.

14. Verfahren nach einem der Ansprüche 8 bis 13, wobei die oberen und unteren Elektroden (12, 18, 22, 28) gebildet werden aus einem Material, das ausgewählt wird aus einer Gruppe, bestehend aus Pt, Ru, Ir, Pd, Au, Cr, Ni, Cu, und TiN mittels eines Sputter-Verfahrens, eines Elektronenstrahlabscheidungsverfahrens oder eines chemischen Gasphasenabscheidungverfahrens.

15. Verfahren nach Anspruch 14, wobei die untere Elektrode (12, 22) aus Ru besteht.

## Revendications

1. Dispositif de mémoire non volatile comprenant un dispositif de commutation et un noeud de stockage connecté au dispositif de commutation, où le noeud de stockage comprend :
une électrode inférieure (12,22) ;
une couche d'oxyde de métal pauvre en oxygène (14,24) formée sur l'électrode inférieure ;
une couche de stockage de données (16,26) formée sur la couche d'oxyde de métal pauvre en oxygène; et
une électrode supérieure (18,28) formée sur la couche de stockage de données,
où le noeud de stockage est configuré pour absorber l'oxygène en cas d'une ou plusieurs vacances d'oxygène de la couche d'oxyde de métal pauvre en oxygène lors de l'application de la tension,
où la couche d'oxyde de métal pauvre en oxygène (14,24) est constituée d'un matériau ayant une vacance d'oxygène choisi dans le groupe composé de ZnO, ITO, IZO, ZrO et RuO₂,
où la couche de stockage de données (16,26) est constituée d'un matériau choisi dans le groupe composé de NiO, Nb₂O₅, TiO₂, Al₂O₃, V₂O₅, WO₃, ZnO et CoO.

2. Dispositif de mémoire non volatile selon la revendication 1, où la couche d'oxyde de métal pauvre en oxygène (14,24) est une couche d'oxyde de métal ayant une vacance d'oxygène et qui présente une résistivité supérieure à un oxyde de métal conducteur et inférieure à la couche de stockage de données.

3. Dispositif de mémoire non volatile selon la revendication 2, où l'oxyde de métal conducteur est constitué d'un matériau choisi dans le groupe composé de IrO₂, RuO₂, SrRuO₃, MoO₂, OsO₂, ReO₂, RhO₂ et WO₂.

4. Dispositif de mémoire non volatile selon la revendication 2 ou la revendication 3, où la couche d'oxyde de métal pauvre en oxygène (14, 24) est une couche de ZnO.

5. Dispositif de mémoire non volatile selon la revendication 4, où la couche d'oxyde de métal pauvre en oxygène (14, 24) a une épaisseur comprise entre 1 et 50 nm.

6. Dispositif de mémoire non volatile selon n'importe quelle revendication précédente, où les électrodes supérieure et inférieure (12,18, 22,28) sont constituées d'un matériau choisi dans le groupe composé de Pt, Ru, Ir, Pd, Au, Cr, Ni, Cu et de TiN.

7. Dispositif de mémoire non volatile selon n'importe quelle revendication précédente, où l'électrode inférieure (12,22) est formée de Ru.

8. Procédé de fabrication d'un dispositif de mémoire non volatile, comprenant :
la préparation d'un dispositif de commutation ;
la formation d'une électrode inférieure (12,22) se connectant à l'appareil de commutation ;
la formation d'une couche d'oxyde de métal pauvre en oxygène (14,24) présentant une vacance d'oxygène sur l'électrode inférieure ;
la formation d'une couche de stockage de données (16,26) sur la couche d'oxyde de métal pauvre en oxygène ; et
la formation d'une électrode supérieure sur la couche de stockage de données ;
où le noeud de stockage est configuré pour absorber l'oxygène en cas d'une ou plusieurs vacances d'oxygène de la couche d'oxyde de métal pauvre en oxygène lors de l'application de la tension ;
où la couche d'oxyde de métal pauvre en oxygène (14,24) est constituée d'un matériau ayant une vacance d'oxygène choisie dans le groupe composé de ZnO, ITO, IZO, ZrO et RuO₂,
où la couche de stockage de données (16,26) est constituée d'un matériau choisi dans le groupe composé de NiO, Nb₂O₅, TiO₂, Al₂O₃, V₂O₅, WO₃, ZnO et CoO.

9. Procédé selon la revendication 8, où la couche d'oxyde de métal pauvre en oxygène (14,24) est constituée d'un matériau choisi dans le groupe composé de ZnO, ITO, IZO, ZrO et RuO₂.

10. Procédé selon la revendication 9, où la couche d'oxyde de métal pauvre en oxygène (14,24) a une épaisseur comprise entre 1 et 50 nm.

11. Procédé selon la revendication 9 ou 10, où la couche d'oxyde de métal pauvre en oxygène (14,24) est formée en utilisant un procédé de pulvérisation, un procédé de dépôt par laser à impulsions, un procédé CVD (dépôt chimique en phase vapeur), un procédé de dépôt en phase vapeur de métal organique, un procédé sol-gel, ou un procédé de décomposition thermique par pulvérisation.

12. Procédé selon les revendications 8, 9 ou 10, où la couche d'oxyde de métal pauvre en oxygène (14,24) est une couche de ZnO.

13. Procédé selon l'une quelconque des revendications 8 à 12, où la couche de ZnO (14,24) est formée en utilisant une cible de ZnO comme matière première à une pression partielle d'oxygène inférieure ou égale à 50% en ajoutant en outre de l'oxygène à une température inférieure ou égale à 50°C en utilisant un procédé de pulvérisation réactive.

14. Procédé selon l'une quelconque des revendications 8 à 13, où les électrodes supérieure et inférieure (12,18,22,28) sont constituées d'un matériau choisi dans le groupe composé de Pt, Ru, Ir, Pd, Au, Cr, Ni, Cu et de TiN en utilisant un procédé de pulvérisation, un procédé de dépôt par faisceau d'électrons ou procédé CVD.

15. Procédé selon la revendication 14, où l'électrode inférieure (12,22) est formée de Ru.
